# EUROPEAN PATENT APPLICATION

(11) **EP 0 605 965 A2**
(43) Date of publication of application: **13.07.1994**
(21) Application number: 93309856.8
(22) Date of filing: 08.12.1993
(51) Int. Cl.: H01L 21/82

(54) **Method of making cmos integrated circuits**

(30) Priority: 31.12.1992 US 999329
(71) Applicant: AT&T Corp., New York, NY 10013-2412 (US)
(72) Inventor: Lee, Kuo-Hua, Wescosville, PA 18106 (US); Liu, Chun-Ting, Wescosville, PA 18106 (US)
(74) Representative: Watts, Christopher Malcolm Kelway, Dr.

(57) **Abstract**

The step height between the regions (5, 7) of different conductivity type in a twin tub CMOS process is reduced by oxidizing the exposed surface of the substrate prior to removal of the oxide regions (3, 9).

## Description

### Technical Field

This invention relates to a method of making integrated circuits having complementary field effect transistors.

### Background of the Invention

Field effect transistors are commonly used in present day integrated circuits. Such transistors may be either n- or p-channel depending upon the carrier conductivity type. For several reasons, including low power consumption, it is desirable to fabricate integrated circuits having both n- and p-channel transistors. These circuits are referred to as CMOS (complementary metal oxide semiconductor) circuits by those skilled in the art.

A CMOS integrated circuit has transistors with both conductivity types, and two ion implantations steps are normally required to form the circuit. Reduction of the number of masks used in integrated circuit fabrication typically reduces the cost of fabrication, and a method for performing the two ion implantation steps without the use of two masks is desirable. Fortunately such a method has been found. See, *United States Patent 4,435,896* issued on March 13, 1984 to Parillo and Payne for a description of the method. This patent, incorporated herein by reference, will be referred to as Parillo. Briefly, in an exemplary embodiment, the method forms and patterns oxide and nitride layers to expose selected portions of the silicon substrate. An ion implantation step of a first conductivity type is then performed, and an oxide layer grown on the exposed portion of the substrate. The remaining nitride portion of the nitride layer is then removed and an ion implantation of a second conductivity type is performed. The grown oxide acts as an implantation mask. The grown oxide is then removed and further processing performed.

With the continued decrease in device dimensions on integrated circuits, factors that were not very important at relatively large device dimensions become important. For example, deviations from surface planarity may make accurate pattern transfer from mask to substrate difficult because of the limited depth of focus of the imaging system used in the transfer process. It is noted that the depth of focus tends to become smaller as device dimensions become smaller. Although it is not explicitly discussed by Parillo, removal of the grown oxide typically leaves the regions of different conductivity types at different heights with respect to the substrate.

Although the difference in height is small and not important for many integrated circuit fabrication processes, it would be desirable to have a method which eliminates or reduces the difference in height noted.

### Summary of the Invention

The invention is as set out in claim 1. CMOS integrated circuits are fabricated by oxidizing the substrate after the second ion implantation step to form a second oxide region and then removing substantially all of the oxide, that is, the second oxide and the first oxide which functioned as an implantation mask for the second ion implantation. A reduced step height between the two regions of differing conductivity types is obtained. The oxidation conditions can be controlled so that the first and second oxide regions have approximately the same final depth and the step height is reduced.

### Brief Description of the Drawing

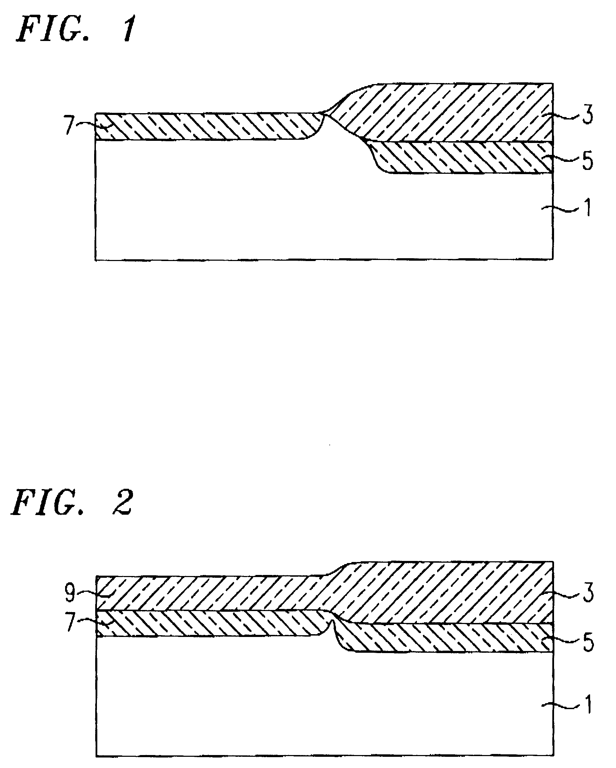

FIGs. 1 and 2 are sectional views of an integrated circuit according to this invention at different stages of fabrication.

For reasons of clarity, the elements depicted are not drawn to scale.

### Detailed Description

The invention will be described by references to a particular embodiment. Depicted in FIG. 1 are substrate 1, first oxide region 3, first ion implant region 5, and second ion implant region 7. The first ion implant region is under the first oxide region 3. The structure depicted will be readily fabricated by those skilled in the art. For example, the twin tub CMOS method taught by Parillo may be used. In one embodiment, a masking layer, for example, nitride is deposited and patterned to expose selected portions of the substrate, a first ion implantation is performed, and a first oxide region formed over the implanted region. The nitride is now removed, and a second ion implantation is now performed to yield the structure depicted. The first oxide region functions as an ion implantation mask. The first and second ion implantations are typically of different conductivity types.

Although it is perhaps not emphasized in FIG. 1, careful examination shows that the silicon surfaces are not at the same height in the two implanted regions, and that removal of the first oxide region maintains a step height at the boundary between the two regions. That is, there is a step height difference between the silicon in the two ion implantation regions 5 and 7. A second oxidation is performed to form a second oxide region 9 as shown in FIG. 2. Oxide regions 3 and 9 have merged. Conventional oxidation conditions may be used although the oxidation conditions, including time, temperature, and pressure, must be controlled to reduce the step height. As can be seen in FIG. 2, the step height has been significantly reduced. This result is not intuitively obvious; naively one would expect the step to remain substantially constant and the first oxide region to increase significantly in depth.

It has, however, not done so. In particular, the oxidation conditions, time, temperature, and pressure, are controlled to reduce the step height. Time and temperature may be used easily. The higher the temperature the greater the reduction in step height for constant time. As time increases, the step height difference also decreases. Ambient pressure is conveniently used. Higher pressures may be used, but will likely encounter practical problems. The step height is reduced because the oxidation rate is inversely proportional to the oxide depth. Thus, the rate of oxidation under the first oxide region can be insignificant compared to the rate of oxidation of the second oxide region. For a first oxide region approximately 200nm (2000 Å) thick, the step height is approximately 87.5nm (875 Å). For a two-hour oxidation in steam, this is reduced to approximately 20nm and 10nm (200 and 100 Å) at temperatures of 1050 and 1150 degrees C, respectively.

At least portions of the first and second oxide regions are now removed. In a preferred embodiment, all of the first and second regions are removed. Conventional device processing to form the integrated circuit is now continued.

It will be recognized that the process described uses some amount of silicon in the oxidation process. The amount of silicon consumed may be reduced by performing the sequence of oxidation and removal several times. Of course, all oxide need not be removed in this process. The step height is reduced incrementally in this process.

Variations in the embodiment described will be readily thought of by those skilled in the art. The second oxidation step may be used as the implant drive-in step for both the n- and p-type implants thus eliminating a conventionally used step.

## Claims

1. A method of fabricating a CMOS integrated circuit comprising the steps of:
forming a masking layer on selected portions of a substrate (1) which exposes selected portions of the substrate;
performing a first ion implantation on said substrate (1), said masking layer acting as an ion implant mask;
oxidizing the exposed portions of said substrate to form a first oxide region (3);
removing said masking layer thereby exposing portions of said substrate (1);
performing a second ion implantation on said substrate (1), said first oxide region (3) acting as an ion implant mask, said first and said second ion implantations have different conductivity types;
oxidizing said portions of said substrate exposed by the removal of said masking layer thereby forming second oxide regions (9), said oxidizing being under conditions selected to reduce the step height of the silicon between the regions of the first (5) and second (7) ion implantations; and
removing substantially all of said first and said second oxide regions (3, 9) to expose said substrate (1).

2. A method as recited in claim 1 in which said first and said second oxide regions (3, 9) have approximately the same depth.

3. A method as recited in claim 1 or claim 2 in which said oxidizing to form second oxide regions (9) and said removing steps are performed at least two times.

4. A method as recited in any of the preceding claims further comprising the step of continuing device processing on said substrate surface.
